# EUROPEAN PATENT APPLICATION

(11) **EP 4 250 318 A1**
(43) Date of publication of application: **27.09.2023**
(21) Application number: 22185907.7
(22) Date of filing: 20.07.2022
(51) Int. Cl.: H01F 3/14, H01F 27/28, H01F 27/29

(54) **MAGNETIC ASSEMBLY**

(30) Priority: 22.03.2022 TW 111110685
(71) Applicant: Elytone Electronic Co. Ltd., Taipei 10679 (TW)
(72) Inventor: HSU, Hao-Te, 237 New Taipei City (TW); CHAO, Li-Chiu, 237 New Taipei City (TW); LIU, Pei-Ying, 237 New Taipei City (TW)
(74) Representative: Becker, Eberhard

(57) **Abstract**

A magnetic assembly (100a, 100b, 100c, 100d, 100e, 100f, 200a, 200b, 200c, 200d, 200e, 200f) includes a first magnetic core (110a, 110c, 210a, 210b, 210c, 210d, 210e, 210f), a second magnetic core (120a, 120d, 220a, 220b, 220c, 220d, 220e, 220f), at least one circuit board (130, 230), and multiple pillars (140a, 140b, 140c, 140d, 140e, 140f). The second magnetic core (120a, 120d, 220a, 220b, 220c, 220d, 220e, 220f) and the first magnetic core (110a, 110c, 210a, 210b, 210c, 210d, 210e, 210f) are assembled with each other to define an internal space (S1, S2). The circuit board (130, 230) is disposed in the internal space (S1, S2). The circuit board (130, 230) has multiple through holes (132, 232) separated from each other. The pillars (140a, 140b, 140c, 140d, 140e, 140f) are located in the internal space (S1, S2) and respectively correspond to the through holes (132, 232) passing through the circuit board (130, 230), and multiple air gaps (A1, A2, A3, A4, B1, B2) are formed between the pillars (140a, 140b, 140c, 140d, 140e, 140f) or between the pillars (140a, 140b, 140c, 140d, 140e, 140f) and at least one of the first magnetic core (110a, 110c, 210a, 210b, 210c, 210d, 210e, 210f) and the second magnetic core (120a, 120d, 220a, 220b, 220c, 220d, 220e, 220f).

## Description

### BACKGROUND

### Technical Field

The disclosure relates to a magnetic assembly, and particularly to a thin type magnetic assembly.

### Description of Related Art

Today's electronic products often use various magnetic assemblies, such as transformers, inductance elements, etc., to meet the required circuit design by the principle of electromagnetic induction. An existing magnetic element uses a single air gap formed between the central pillars of two magnetic cores to prevent magnetic saturation. However, if the spacing of the single air gap is too large, it will cause higher magnetic loss, resulting in increased energy loss. Furthermore, currently, a magnetic element with an air gap needs to use a winding set, the coil is wound on a winding frame, and the winding frame is fixed between two magnetic cores. Thus, such a magnetic element cannot effectively achieve a light and thin type. In order to respond to light type electrical equipment, magnetic elements and winding sets used inside also need to develop toward thin types, so as to reduce the overall volume of electrical equipment. Therefore, how to get a thin type magnetic assembly while improving efficiency and reducing magnetic loss and leakage inductance has become one of the problems that need to be solved urgently in the art.

### SUMMARY

The disclosure provides a magnetic assembly, which has the advantages of high efficiency, low leakage inductance, and low magnetic loss, and may meet the requirement of a thin type.

A magnetic assembly of the disclosure includes a first magnetic core, a second magnetic core, at least one circuit board, and multiple pillars. The second magnetic core and the first magnetic core are assembled with each other to define an internal space. The circuit board is disposed in the internal space. Moreover, the circuit board has multiple through holes separated from each other. The pillars are located in the internal space and respectively correspond to the through holes passing through the circuit board, and multiple air gaps are formed between the pillars or between the pillars and at least one of the first magnetic core and the second magnetic core.

In an embodiment of the disclosure, the above-mentioned pillars have the same height and are disposed on the first magnetic core. Air gaps of the same spacing are formed between the pillars and the second magnetic core.

In an embodiment of the disclosure, the above-mentioned pillars have the same height and are disposed on the second magnetic core. Air gaps of the same spacing are formed between the pillars and the first magnetic core.

In an embodiment of the disclosure, the above-mentioned pillars have the same height, and the air gaps include multiple first air gaps and multiple second air gaps. The first air gaps of the same spacing are formed between the pillars and the first magnetic core, the second air gaps of the same spacing are formed between the pillars and the second magnetic core, and the spacing of the first air gaps is the same as the spacing of the second air gaps.

In an embodiment of the disclosure, the above-mentioned pillars have the same height, and the air gaps include multiple first air gaps and multiple second air gaps. The first air gaps of the same spacing are formed between the pillars and the first magnetic core, the second air gaps of the same spacing are formed between the pillars and the second magnetic core, and the spacing of the first air gaps is different from the spacing of the second air gaps.

In an embodiment of the disclosure, the above-mentioned pillars include multiple first pillars and multiple second pillars. The first pillars are disposed on the first magnetic core, the second pillars are disposed on the second magnetic core, and air gaps of the same spacing are formed between the first pillars and the corresponding second pillars.

In an embodiment of the disclosure, the above-mentioned pillars have the same height, and the pillars include at least one first pillar and at least one second pillar. The air gaps include at least one first air gap and at least one second air gap. The first pillar is disposed on the first magnetic core, and the second pillar is disposed on the second magnetic core. The first air gap is formed between the first pillar and the second magnetic core, the second air gap is formed between the second pillar and the first magnetic core, and the spacing of the first air gap and the spacing of the second air gap is the same.

In an embodiment of the disclosure, the above-mentioned first pillar and the first magnetic core are integrally formed, and the second pillar and the second magnetic core are integrally formed.

In an embodiment of the disclosure, the above-mentioned pillars include at least one first pillar and at least one second pillar, and the height of the first pillar is different from the height of the second pillar. The air gaps include at least one first air gap and at least one second air gap. One of the first pillar and the second pillar is disposed on the first magnetic core, and the other of the first pillar and the second pillar is disposed on the second magnetic core. The first air gap is formed between the first pillar and one of the first magnetic core and the second magnetic core, the second air gap is formed between the second pillar and the other of the first magnetic core and the second magnetic core, and the spacing of the first air gap is different from the spacing of the second air gap.

In an embodiment of the disclosure, the above-mentioned first pillar and one of the first magnetic core and the second magnetic core are integrally formed, and the second pillar and the other of the first magnetic core and the second magnetic core are integrally formed.

In an embodiment of the disclosure, one of the first magnetic core and the second magnetic core described above is in the shape of a flat plate, and the other of the first magnetic core and the second magnetic core is in the shape of a groove.

In an embodiment of the disclosure, the above-mentioned first magnetic core and the second magnetic core are in the shape of a groove, respectively.

In an embodiment of the disclosure, the above-mentioned magnetic assembly further includes multiple connecting members. The circuit board further has multiple connecting holes around, and the connecting members correspond to the pass through connecting holes, respectively.

Based on the above, in the design of the magnetic assembly of the disclosure, the pillars respectively correspond to the through holes passing through the circuit board, and the air gaps are formed between the pillars or between the pillars and at least one of the first magnetic core and the second magnetic core. In this way, the work efficiency of the magnetic assembly of the disclosure may be improved, thereby having the advantages of high efficiency, low magnetic loss, and low leakage inductance.

In order to make the aforementioned features and advantages of the disclosure comprehensible, embodiments accompanied with drawings are described in detail as follows.

### BRIEF DESCRIPTION OF THE DRAWINGS

FIG. 1A is a schematic perspective view of a magnetic assembly according to an embodiment of the disclosure.
FIG. 1B is an exploded schematic view of the magnetic assembly of FIG. 1A.
FIG. 1C is a schematic cross-sectional view of the magnetic assembly of FIG. 1A along a line A-A.
FIG. 2A is a schematic cross-sectional view of a magnetic assembly according to an embodiment of the disclosure.
FIG. 2B is a schematic cross-sectional view of a magnetic assembly according to another embodiment of the disclosure.
FIG. 2C is a schematic cross-sectional view of a magnetic assembly according to another embodiment of the disclosure.
FIG. 2D is a schematic cross-sectional view of a magnetic assembly according to another embodiment of the disclosure.
FIG. 2E is a schematic cross-sectional view of a magnetic assembly according to another embodiment of the disclosure.
FIG. 3A is an exploded schematic view of a magnetic assembly according to another embodiment of the disclosure.
FIG. 3B is a schematic cross-sectional view of the magnetic assembly of FIG. 3A.
FIG. 3C is a schematic cross-sectional view of a magnetic assembly according to another embodiment of the disclosure.
FIG. 4A is a schematic cross-sectional view of a magnetic assembly according to another embodiment of the disclosure.
FIG. 4B is a schematic cross-sectional view of a magnetic assembly according to another embodiment of the disclosure.
FIG. 4C is a schematic cross-sectional view of a magnetic assembly according to another embodiment of the disclosure.
FIG. 4D is a schematic cross-sectional view of a magnetic assembly according to another embodiment of the disclosure.

### DESCRIPTION OF THE EMBODIMENTS

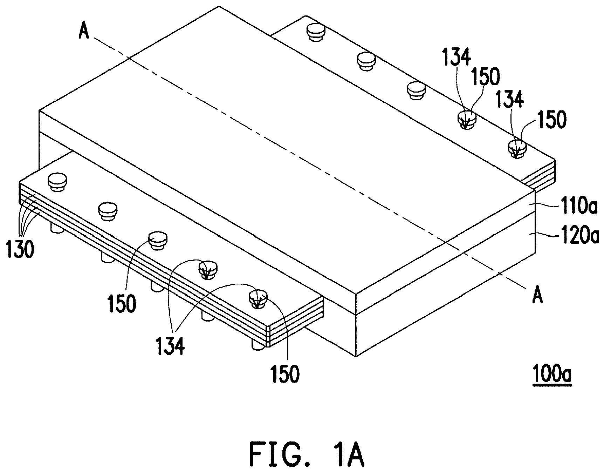

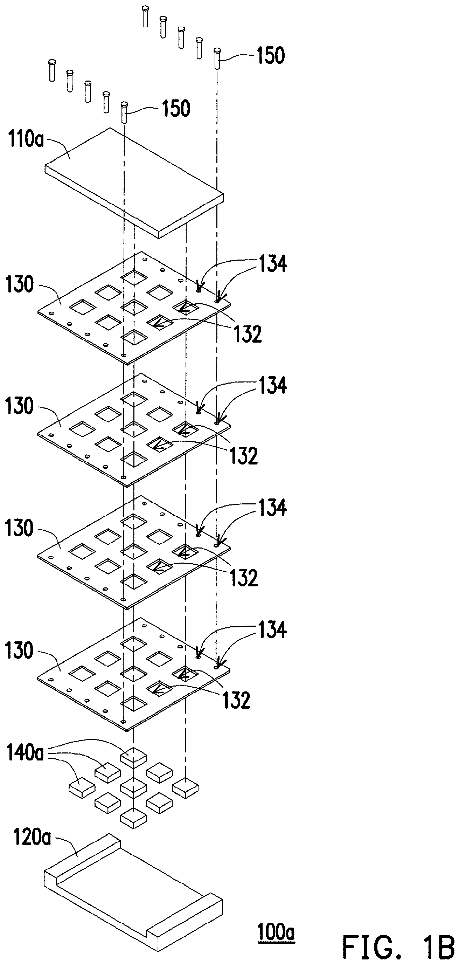

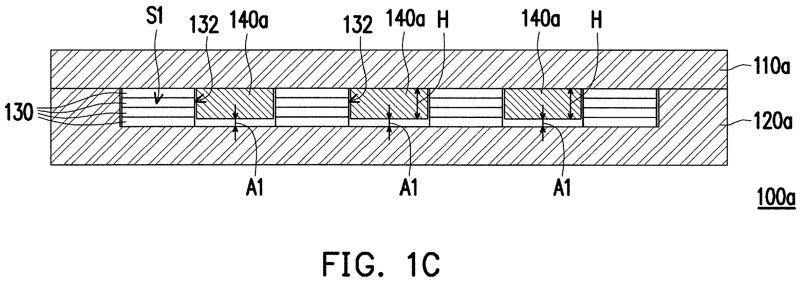

FIG. 1A is a schematic perspective view of a magnetic assembly according to an embodiment of the disclosure. FIG. 1B is an exploded schematic view of the magnetic assembly of FIG. 1A. FIG. 1C is a schematic cross-sectional view of the magnetic assembly of FIG. 1A along a line A-A. Please refer to FIGS. 1A, 1B, and 1C at the same time. In the embodiment, a magnetic assembly 100a includes a first magnetic core 110a, a second magnetic core 120a, at least one circuit board 130 (multiple circuit boards 130 are schematically shown), and multiple pillars 140a. The second magnetic core 120a and the first magnetic core 110a are assembled with each other to define an internal space S1. The circuit boards 130 are stacked corresponding to each other and disposed in the internal space S1. Each of the circuit boards 130 has multiple through holes 132 separated from each other, and the through holes 132 of the circuit boards 130 are disposed corresponding to each other. The pillars 140a are located in the internal space S1 and respectively correspond to the through holes 132 passing through the circuit boards 130, and multiple air gaps A1 are formed between the pillars 140a or between the pillars 140a and at least one of the first magnetic 110a core and the second magnetic core 120a.

In detail, in the embodiment, one of the first magnetic core 110a and the second magnetic core 120a is in the shape of a flat plate, and the other of the first magnetic core 110a and the second magnetic core 120a is in the shape of a groove. In the schematic views, the first magnetic core 110a is in the shape of the flat plate, the second magnetic core 120a is in the shape of the groove, and the second magnetic core 120a and the first magnetic core 110a are assembled with each other to define the U-shaped internal space S1, which is not limited thereto. The material of the first magnetic core 110a and the second magnetic core 120a are, for example, ferrite, silicon steel sheets, or iron-nickel alloy, but the disclosure is not limited thereto.

Furthermore, the circuit boards 130 are, for example, printed circuit boards, and the circuit boards 130 are directly in contact with each other and stacked with each other. In the embodiment, the circuit boards 130 have the same size, but are not limited thereto, as long as the through holes 132 on the circuit boards 130 can correspond to each other. In particular, the pillars 140a of the embodiment have the same height, and are disposed on the first magnetic core 110a. The pillars 140a correspond to the through holes 132 passing through the circuit boards 130, respectively, and the air gaps A1 of the same spacing are formed between the pillars 140a and the second magnetic core 120a. In the embodiment, the material of the pillars 140a are, for example, ferrite, silicon steel sheets, or iron-nickel alloy, but the disclosure is not limited thereto. In some embodiments, the material of the pillars 140a may be the same as or different from the materials of the first magnetic core 110a and the second magnetic core 120a, which is not limited thereto.

It should be noted that, as shown in FIG. 1B, in the embodiment, the shape of the through holes 132 on each of the circuit boards 130 is a square, and the shape of the pillars 140a is a cube, but are not limited thereto. In other non-illustrated embodiments, the shape of the through holes 132 may be a circle or other suitable shapes, and the shape of the pillars 140a may be a cylinder or other suitable shapes. Alternatively, the shape of the through holes 132 and the shape of the pillars 140a do not correspond to each other. For example, the shape of the through holes 132 is a square, but the shape of the pillars 140a is a cylinder, which still belongs to the scope of the disclosure. Furthermore, the through holes 132 on the circuit board 130 are arranged in a matrix, but are not limited thereto. In other non-illustrated embodiments, the through holes 132 on the circuit board 130 may be arranged regularly or irregularly, as long as the number of the pillars 140a and the number of the through holes 132 are the same and correspondingly disposed, which all belongs to the scope of the disclosure. In addition, the pillars 140a may be fixed in the through holes 132 of the circuit board 130 through an adhesive material (not shown) or other suitable means.

In addition, referring to FIGS. 1A and 1B at the same time, the magnetic assembly 100a of the embodiment further includes multiple connecting members 150, and each of the circuit boards 130 further has multiple connecting holes 134 around. The connecting holes 134 of each of the circuit boards 130 are disposed correspondingly to each other, and the connecting members 150 respectively correspond to the pass through connecting holes 134. In the embodiment, the connecting members 150 and the connecting holes 134 are both located outside the first magnetic core 110a and the second magnetic core 120a, and the circuit boards 130 may be electrically connected to an external circuit through the connecting members 150.

Generally speaking, since the air gap leakage flux is equivalent to a semicircle or an arcuate shape with the gap of the air gap as a straight side on the cross section of the magnetic core, with the increase in the height of the air gap, the cross-sectional area of the leakage flux increases in square multiples, and for the actual three-dimensional space, the space increases in cubic multiples. Therefore, in the embodiment, the air gaps A1 with a single spacing are formed through the pillars 140a, in addition to the effect of preventing magnetic saturation, such a formation may also greatly reduce and disperse the magnetic leakage loss, reduce the diffused magnetic flux, and enable the magnetic assembly 100a to have low leakage inductance and low magnetic loss, thereby improving work efficiency.

In short, in the embodiment, the winding sets in the prior art are replaced by the pillars 140a corresponding to the through holes 132 passing through the circuit boards 130, thereby enabling the magnetic assembly 100a to not only have the advantages of a thin type but also have the advantages of convenient assembly. Moreover, as the air gaps A1 with a single spacing are formed through the pillars 140a, in addition to the effect of preventing magnetic saturation, the magnetic assembly 100a may also be enabled to have the advantages of high efficiency, low magnetic loss, and low leakage inductance.

It must be noted here that the following embodiments use the element numerals and part of the contents of the foregoing embodiments, the same numerals are used to denote the same or similar elements, and the description of the same technical content is omitted. For the description of the omitted parts, reference may be made to the foregoing embodiments, and thus the description is not repeated in the following embodiments.

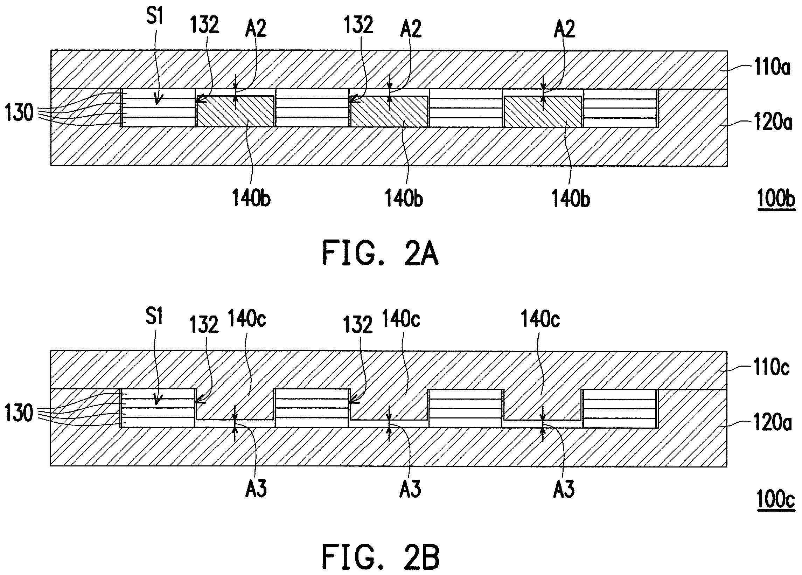

FIG. 2A is a schematic cross-sectional view of a magnetic assembly according to an embodiment of the disclosure. Please refer to FIGS. 1C and 2A at the same time. A magnetic assembly 100b of the embodiment is similar to the magnetic assembly 100a of the above-mentioned embodiment. The difference between the two is that in the embodiment, pillars 140b are disposed on the second magnetic core 120a, and air gaps A2 of the same spacing are formed between the pillars 140b and the first magnetic core 110a.

FIG. 2B is a schematic cross-sectional view of a magnetic assembly according to another embodiment of the disclosure. Please refer to FIGS. 1C and 2B at the same time. A magnetic assembly 100c of the embodiment is similar to the magnetic assembly 100a of the above-mentioned embodiment. The difference between the two is that in the embodiment, pillars 140c and a first magnetic core 110c are integrally formed, and air gaps A3 of the same spacing are formed between the pillars 140c and the second magnetic core 120a. That is, the pillars 140c and the first magnetic core 110c in the embodiment have the same material. By the integral formation of the pillars 140c and the first magnetic core 110c, the assembly yield between the pillars 140c and the circuit boards 130 may be improved to prevent the pillars 140c from falling off the circuit boards 130.

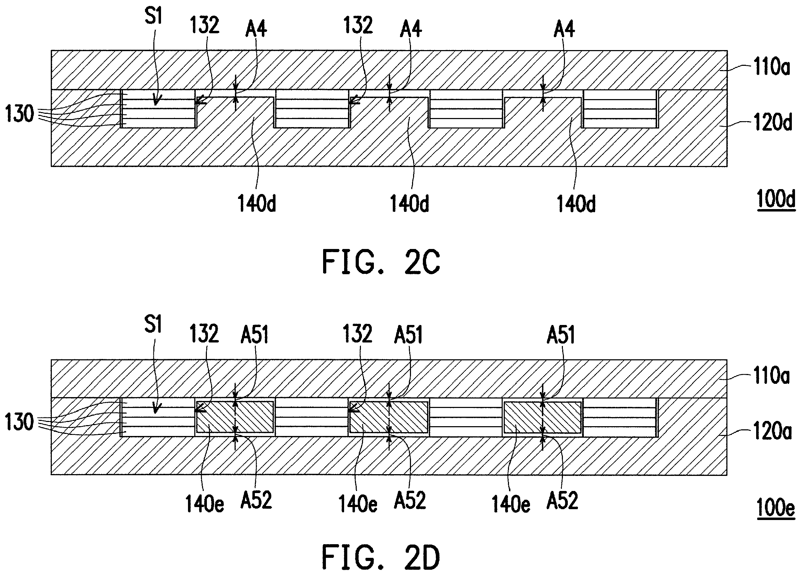

FIG. 2C is a schematic cross-sectional view of a magnetic assembly according to another embodiment of the disclosure. Please refer to FIGS. 2A and 2C at the same time. A magnetic assembly 100d of the embodiment is similar to the magnetic assembly 100b of the above-mentioned embodiment. The difference between the two is that in the embodiment, pillars 140d and a second magnetic core 120d are integrally formed, and air gaps A4 of the same spacing are formed between the pillars 140d and the first magnetic core 110a. That is, the pillars 140d and the second magnetic core 120d in the embodiment have the same material. By the integral formation of the pillars 140d and the second magnetic core 120d, the assembly yield between the pillars 140d and the circuit boards 130 may be improved to prevent the pillars 140d from falling off the circuit boards 130.

FIG. 2D is a schematic cross-sectional view of a magnetic assembly according to another embodiment of the disclosure. Please refer to FIGS. 1C and 2D at the same time. A magnetic assembly 100e of the embodiment is similar to the magnetic assembly 100a of the above-mentioned embodiment. The difference between the two is that the air gaps of the embodiment includes multiple first air gaps A51 and multiple second air gaps A52. The first air gaps A51 of the same spacing are formed between pillars 140e and the first magnetic core 110a, the second air gaps A52 of the same spacing are formed between the pillars 140e and the second magnetic core 120a, and the spacing of the first air gaps A51 and the spacing of the second air gaps A52 are the same. In the embodiment, the pillars 140e are fixed in the through holes 132 of the circuit boards 130 without being in contact with the first magnetic core 110a and the second magnetic core 120a. That is, in the embodiment, the first air gaps A51 and the second air gaps A52 of the same spacing are formed through the pillars 140e, and in addition to the effect of preventing magnetic saturation, the magnetic assembly 100e may also be enabled to have the advantages of high efficiency, a thin type, easy assembly, high process production efficiency, low magnetic loss, and low leakage inductance.

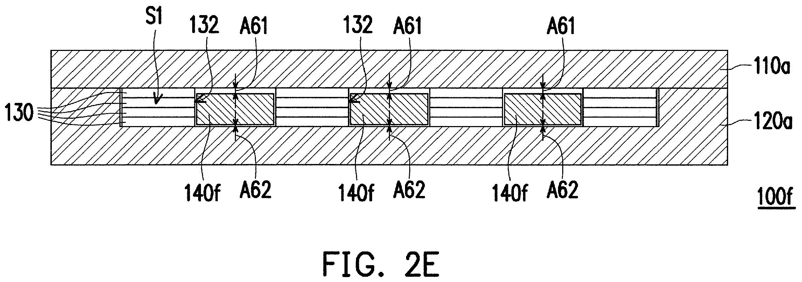

FIG. 2E is a schematic cross-sectional view of a magnetic assembly according to another embodiment of the disclosure. Please refer to FIGS. 2D and 2E at the same time. A magnetic assembly 100f of the embodiment is similar to the magnetic assembly 100e of the above-mentioned embodiment. The difference between the two is that the spacing of first air gaps A61 formed between pillars 140f and the first magnetic core 110a is different from the spacing of second air gaps A62 formed between the pillars 140f and the second magnetic core 120a. In the embodiment, the pillars 140f are relatively close to the second magnetic core 120a, so that the spacing of the first air gaps A61 is greater than the spacing of the second air gaps A62. That is, in the embodiment, the first air gaps A61 and the second air gaps A62 of different spacing are formed through the pillars 140f, and in addition to the effect of preventing magnetic saturation, the magnetic assembly 100f may also be enabled to have the advantages of high efficiency, a thin type, easy assembly, high process production efficiency, low magnetic loss, and low leakage inductance.

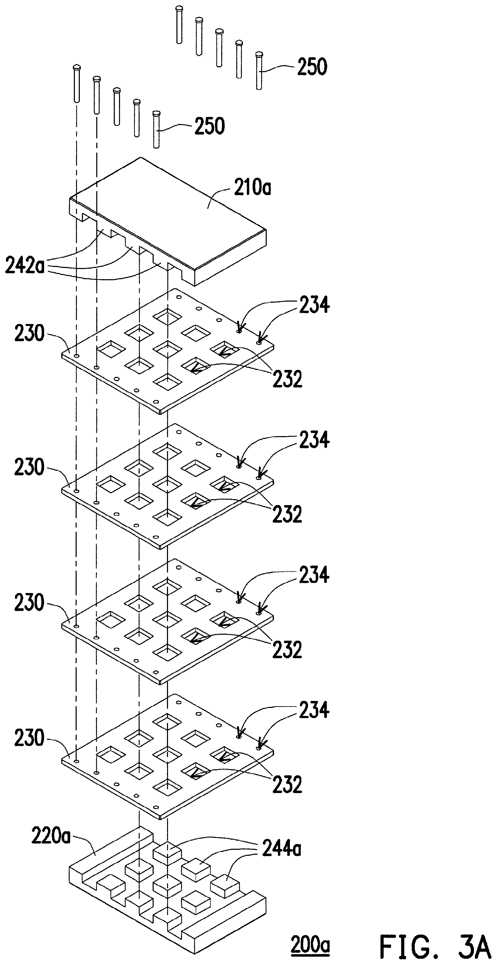

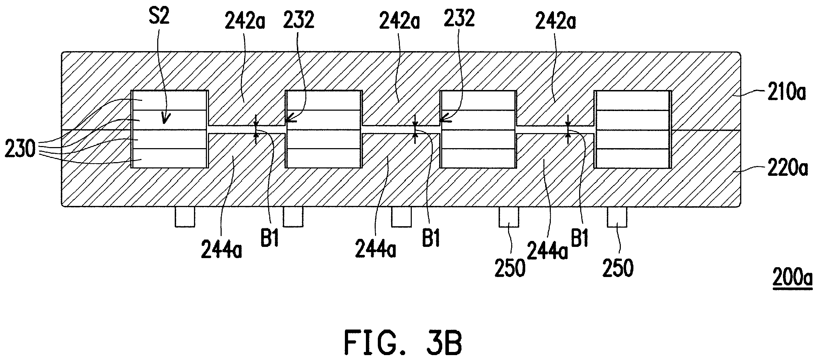

FIG. 3A is an exploded schematic view of a magnetic assembly according to another embodiment of the disclosure. FIG. 3B is a schematic cross-sectional view of the magnetic assembly of FIG. 3A. Please refer to FIGS. 1B and 3A at the same time. A magnetic assembly 200a of the embodiment is similar to the magnetic assembly 100a of the above-mentioned embodiment. The difference between the two is that a first magnetic core 210a and a second magnetic core 220a of the embodiment are respectively in the shape of a groove, and pillars include multiple first pillars 242a and multiple second pillars 244a. In detail, please refer to FIGS. 3A and 3B at the same time. The first magnetic core 210a and the second magnetic core 220a are assembled with each other to define an internal space S2. Circuit boards 230, the first pillars 242a and the second pillars 244a are stacked correspondingly, and are all located in the internal space S2. Connecting holes 234 of the circuit boards 230 are located outside the first magnetic core 210a and the second magnetic core 220a, and connecting members 250 respectively correspond to the pass through connecting holes 234, so that the circuit boards 230 may be electrically connected to an external circuit. Furthermore, in the embodiment, the first pillars 242a are disposed on the first magnetic core 210a, and the first pillars 242a and the first magnetic core 210a are integrally formed. The second pillars 244a are disposed on the second magnetic core 220a, and the second pillars 244a and the second magnetic core 220a are integrally formed. The number of the first pillars 242a corresponds to the number of the second pillars 244a, and air gaps B1 of the same spacing are formed between the first pillars 242a and the corresponding second pillars 244a. Therefore, the magnetic assembly 200a of the embodiment has the advantages of high efficiency, a thin type, easy assembly, high process production efficiency, low magnetic loss, and low leakage inductance.

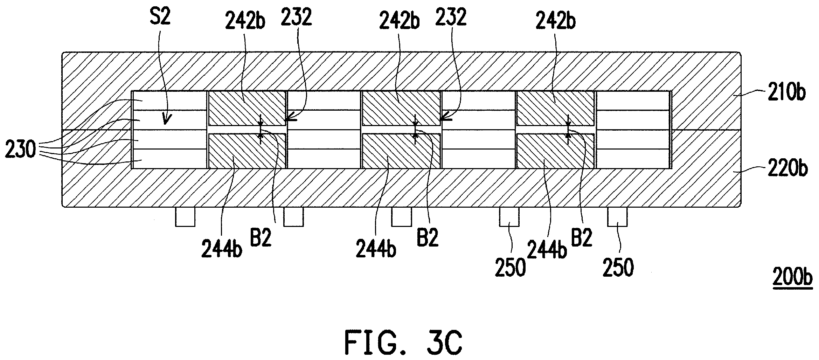

FIG. 3C is a schematic cross-sectional view of a magnetic assembly according to another embodiment of the disclosure. Please refer to FIGS. 3B and 3C at the same time. A magnetic assembly 200b of the embodiment is similar to the magnetic assembly 200a of the above-mentioned embodiment. The difference between the two is that in the embodiment, first pillars 242b are disposed on a first magnetic core 210b, and the first pillars 242b and the first magnetic core 210b are separate components. Second pillars 244b are disposed on a second magnetic core 220b, and the second pillars 244b and the second magnetic core 220b are separate components. Air gaps B2 of the same spacing are formed between the first pillars 242b and the corresponding second pillars 244b.

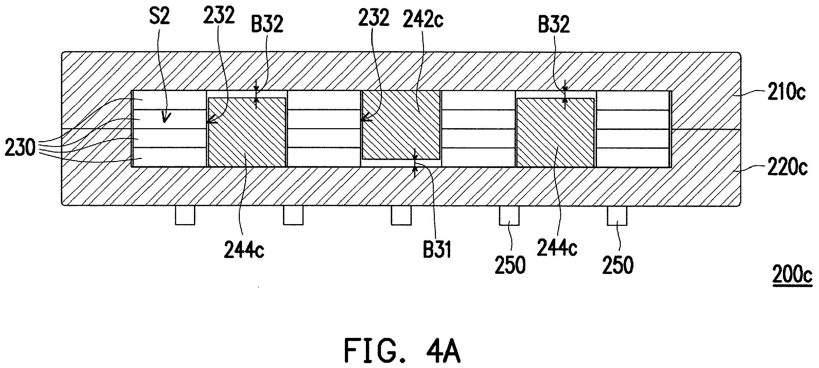

FIG. 4A is a schematic cross-sectional view of a magnetic assembly according to another embodiment of the disclosure. Please refer to FIGS. 3C and 4A at the same time. A magnetic assembly 200c of the embodiment is similar to the magnetic assembly 200b of the above-mentioned embodiment. The difference between the two is that in the embodiment, the number of first pillars 242c is different from the number of second pillars 244c. For example, the first pillar 242c in the embodiment is schematically shown as one, and the second pillar 244c is schematically shown as two, but the disclosure is not limited thereto. The first pillar 242c is disposed on a first magnetic core 210c, and at least one first air gap B31 (one first air gap B31 is schematically shown) is formed between the first pillar 242c and a second magnetic core 220c. The second pillars 244c are disposed on the second magnetic core 220c, and at least one second air gap B32 (two second air gaps B32 are schematically shown) is formed between the second pillars 244c and the first magnetic core 210c. In the embodiment, the spacing of the first air gap B31 is the same as the spacing of the second air gap B32. In detail, the first pillar 242c and the second pillars 244c in the embodiment are disposed alternately, so that the orthographic projection of the first pillar 242c on the second magnetic core 220c does not overlap with the second pillars 244c. That is, in the embodiment, the first air gap B31 and the second air gaps B32 of the same spacing are formed through the first pillar 242c and the second pillars 244c, and in addition to the effect of preventing magnetic saturation, the magnetic assembly 200c may also be enabled to have the advantages of high efficiency, a thin type, easy assembly, high process production efficiency, low magnetic loss, and low leakage inductance.

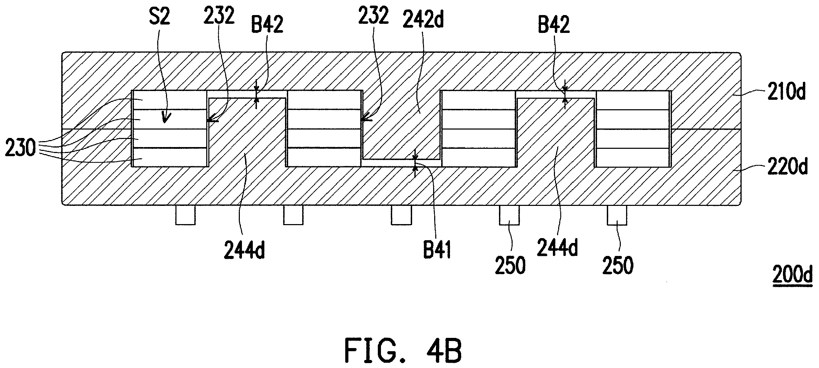

FIG. 4B is a schematic cross-sectional view of a magnetic assembly according to another embodiment of the disclosure. Please refer to FIGS. 4A and 4B at the same time. The difference between a magnetic assembly 200d of the embodiment and the magnetic assembly 200c of the above-mentioned embodiment is that a first pillar 242d and a first magnetic core 210d of the embodiment are integrally formed, and second pillars 244d and a second magnetic core 220d are integrally formed. A first air gap B41 is formed between the first pillar 242d and the second magnetic core 220d, second air gaps B42 are formed between the second pillars 244d and the first magnetic core 210d, and the spacing of the first air gap B41 is the same as the spacing of the second air gaps B42.

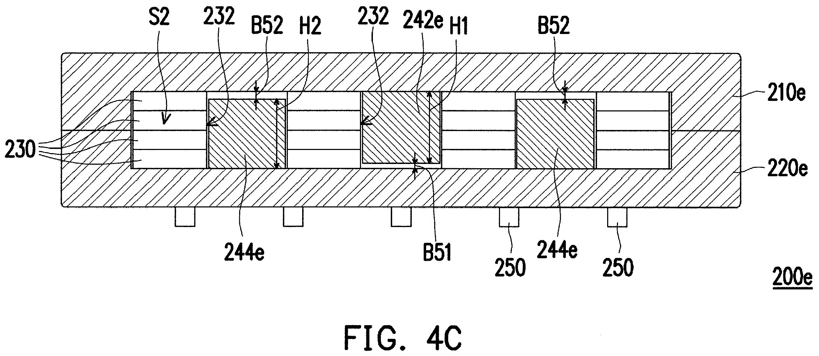

FIG. 4C is a schematic cross-sectional view of a magnetic assembly according to another embodiment of the disclosure. Please refer to FIGS. 4A and 4C at the same time. The difference between a magnetic assembly 200e of the embodiment and the magnetic assembly 200c of the above-mentioned embodiment is that a height H1 of a first pillar 242e of the embodiment is greater than a height H2 of a second pillar 244e, so that the spacing of a first air gap B51 is different from the spacing of second air gaps B52. In detail, the first air gap B51 is formed between the first pillar 242e and a second magnetic core 220e, the second air gaps B52 are formed between the second pillars 244e and a first magnetic core 210e, and the spacing of the first air gap B51 is less than the spacing of the second air gaps B52. That is, in the embodiment, the first air gap B51 and the second air gaps B52 of different spacing are formed through the first pillar 242e and the second pillars 244e, and in addition to the effect of preventing magnetic saturation, the magnetic assembly 200e may also be enabled to have the advantages of high efficiency, a thin type, easy assembly, high process production efficiency, low magnetic loss, and low leakage inductance.

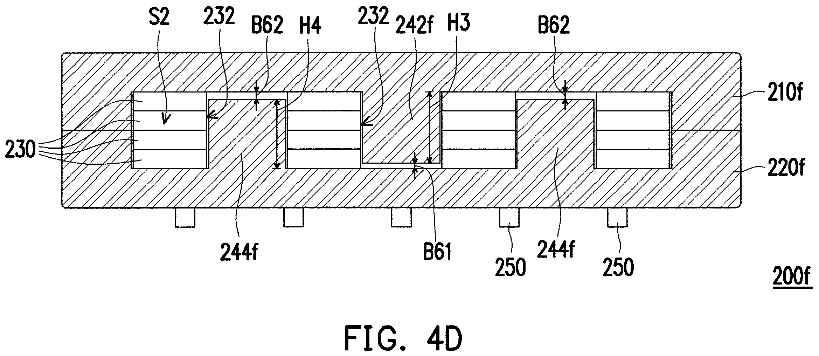

FIG. 4D is a schematic cross-sectional view of a magnetic assembly according to another embodiment of the disclosure. Please refer to FIGS. 4B and 4D at the same time. A magnetic assembly 200f of the embodiment is similar to the magnetic assembly 200d of the above-mentioned embodiment. The difference between the two is that a height H3 of a first pillar 242f of the embodiment is greater than a height H4 of a second pillar 244f, so that the spacing of a first air gap B61 is different from the spacing of second air gaps B62. In detail, the first air gap B61 is formed between the first pillar 242f and a second magnetic core 220f, the second air gaps B62 are formed between the second pillars 244f and a first magnetic core 210f, and the spacing of the first air gap B61 is smaller than the spacing of the second air gaps B62. That is, in the embodiment, the first air gap B61 and the second air gaps B62 of different spacing are formed through the first pillar 242f and the second pillars 244f, and in addition to the effect of preventing magnetic saturation, the magnetic assembly 200f may also be enabled to have the advantages of high efficiency, a thin type, easy assembly, high process production efficiency, low magnetic loss, and low leakage inductance.

In summary, in the design of the magnetic assembly of the disclosure, the pillars respectively correspond to the through holes passing through the circuit boards, and the air gaps are formed between the pillars or between the pillars and at least one of the first magnetic core and the second magnetic core. In this way, the work efficiency of the magnetic assembly of the disclosure may be improved, and has the advantages of high efficiency, low magnetic loss, and low leakage inductance. In addition, by replacing the existing winding sets with circuit boards stacked on each other, the thin type effect may be achieved, so that the magnetic assembly of the disclosure can meet the current requirements for the thin type electrical equipment.

## Claims

1. A magnetic assembly (100a, 100b, 100c, 100d, 100e, 100f, 200a, 200b, 200c, 200d, 200e, 200f), comprising:
a first magnetic core (110a, 110c, 210a, 210b, 210c, 210d, 210e, 210f);
a second magnetic core (120a, 120d, 220a, 220b, 220c, 220d, 220e, 220f), assembled with the first magnetic core (110a, 110c, 210a, 210b, 210c, 210d, 210e, 210f) to define an internal space(S1, S2);
at least one circuit board (130, 230), disposed in the internal space (SI, S2), wherein the at least one circuit board (130, 230) has a plurality of through holes (132, 232) separated from each other; and
a plurality of pillars (140a, 140b, 140c, 140d, 140e, 140f), located in the internal space (S1, S2) and respectively corresponding to the plurality of through holes (132, 232) passing through the at least one circuit board (130, 230), and a plurality of air gaps (A1, A2, A3, A4, B1, B2) being formed between the plurality of pillars (140a, 140b, 140c, 140d, 140e, 140f) or between the plurality of pillars (140a, 140b, 140c, 140d, 140e, 140f) and at least one of the first magnetic core (110a, 110c, 210a, 210b, 210c, 210d, 210e, 210f) and the second magnetic core (120a, 120d, 220a, 220b, 220c, 220d, 220e, 220f).

2. The magnetic assembly (100a, 100b, 100c, 100d, 100e, 100f, 200a, 200b, 200c, 200d, 200e, 200f) according to claim 1, wherein the plurality of pillars (140a, 140b, 140c, 140d, 140e, 140f) have the same height and are disposed on the first magnetic core (110a, 110c, 210a, 210b, 210c, 210d, 210e, 210f), and the plurality of air gaps (A1, A2, A3, A4, B1, B2) of the same spacing are formed between the plurality of pillars (140a, 140b, 140c, 140d, 140e, 140f) and the second magnetic core (120a, 120d, 220a, 220b, 220c, 220d, 220e, 220f).

3. The magnetic assembly (100a, 100b, 100c, 100d, 100e, 100f, 200a, 200b, 200c, 200d, 200e, 200f) according to claim 1, wherein the plurality of pillars (140a, 140b, 140c, 140d, 140e, 140f) have the same height and are disposed on the second magnetic core (120a, 120d, 220a, 220b, 220c, 220d, 220e, 220f), and the plurality of air gaps (A1, A2, A3, A4, B1, B2) of the same spacing are formed between the plurality of pillars (140a, 140b, 140c, 140d, 140e, 140f) and the first magnetic core (110a, 110c, 210a, 210b, 210c, 210d, 210e, 210f).

4. The magnetic assembly (100a, 100b, 100c, 100d, 100e, 100f, 200a, 200b, 200c, 200d, 200e, 200f) according to claim 1, wherein the plurality of pillars (140a, 140b, 140c, 140d, 140e, 140f) have the same height, the plurality of air gaps (A1, A2, A3, A4, B1, B2) comprise a plurality of first air gaps (A51, A61, B31, B41, B51, B61) and a plurality of second air gaps (A52, A62, B32, B42, B52, B62), the plurality of first air gaps (A51, A61, B31, B41, B51, B61) of the same spacing are formed between the plurality of pillars (140a, 140b, 140c, 140d, 140e, 140f) and the first magnetic core (110a, 110c, 210a, 210b, 210c, 210d, 210e, 210f), the plurality of second air gaps (A52, A62, B32, B42, B52, B62) of the same spacing are formed between the plurality of pillars (140a, 140b, 140c, 140d, 140e, 140f) and the second magnetic core (120a, 120d, 220a, 220b, 220c, 220d, 220e, 220f), and the spacing of the plurality of first air gaps (A51, A61, B31, B41, B51, B61) is the same as the spacing of the plurality of second air gaps (A52, A62, B32, B42, B52, B62).

5. The magnetic assembly (100a, 100b, 100c, 100d, 100e, 100f, 200a, 200b, 200c, 200d, 200e, 200f) according to claim 1, wherein the plurality of pillars (140a, 140b, 140c, 140d, 140e, 140f) have the same height, the plurality of air gaps (A1, A2, A3, A4, B1, B2) comprise a plurality of first air gaps (A51, A61, B31, B41, B51, B61) and a plurality of second air gaps (A52, A62, B32, B42, B52, B62), the plurality of first air gaps (A51, A61, B31, B41, B51, B61) of the same spacing are formed between the plurality of pillars (140a, 140b, 140c, 140d, 140e, 140f) and the first magnetic core (110a, 110c, 210a, 210b, 210c, 210d, 210e, 210f), the plurality of second air gaps (A52, A62, B32, B42, B52, B62) of the same spacing are formed between the plurality of pillars (140a, 140b, 140c, 140d, 140e, 140f) and the second magnetic core (120a, 120d, 220a, 220b, 220c, 220d, 220e, 220f), and the spacing of the plurality of first air gaps (A51, A61, B31, B41, B51, B61) is different from the spacing of the plurality of second air gaps (A52, A62, B32, B42, B52, B62).

6. The magnetic assembly (100a, 100b, 100c, 100d, 100e, 100f, 200a, 200b, 200c, 200d, 200e, 200f) according to claim 1, wherein the plurality of pillars (140a, 140b, 140c, 140d, 140e, 140f) comprise a plurality of first pillars (242a, 242b, 242c, 242d, 242e, 242f) and a plurality of second pillars (244a, 244b, 244c, 244d, 244e, 244f), the plurality of first pillars (242a, 242b, 242c, 242d, 242e, 242f) are disposed on the first magnetic core (110a, 110c, 210a, 210b, 210c, 210d, 210e, 210f), the plurality of second pillars (244a, 244b, 244c, 244d, 244e, 244f) are disposed on the second magnetic core (120a, 120d, 220a, 220b, 220c, 220d, 220e, 220f), and the plurality of air gaps (A1, A2, A3, A4, B1, B2) of the same spacing are formed between the plurality of first pillars (242a, 242b, 242c, 242d, 242e, 242f) and the corresponding plurality of second pillars (244a, 244b, 244c, 244d, 244e, 244f).

7. The magnetic assembly (100a, 100b, 100c, 100d, 100e, 100f, 200a, 200b, 200c, 200d, 200e, 200f) according to claim 1, wherein the plurality of pillars (140a, 140b, 140c, 140d, 140e, 140f) have the same height, the plurality of pillars (140a, 140b, 140c, 140d, 140e, 140f) comprise at least one first pillar (242a, 242b, 242c, 242d, 242e, 242f) and at least one second pillar (244a, 244b, 244c, 244d, 244e, 244f), the plurality of air gaps (A1, A2, A3, A4, B1, B2) comprise at least one first air gap (A51, A61, B31, B41, B51, B61) and at least one second air gap (A52, A62, B32, B42, B52, B62), the at least one first pillar (242a, 242b, 242c, 242d, 242e, 242f) is disposed on the first magnetic core (110a, 110c, 210a, 210b, 210c, 210d, 210e, 210f), the at least one second pillar (244a, 244b, 244c, 244d, 244e, 244f) is disposed on the second magnetic core (120a, 120d, 220a, 220b, 220c, 220d, 220e, 220f), the at least one first air gap (A51, A61, B31, B41, B51, B61) is formed between the at least one first pillar (242a, 242b, 242c, 242d, 242e, 242f) and the second magnetic core (120a, 120d, 220a, 220b, 220c, 220d, 220e, 220f), the at least one second air gap (A52, A62, B32, B42, B52, B62) is formed between the at least one second pillar (244a, 244b, 244c, 244d, 244e, 244f) and the first magnetic core (110a, 110c, 210a, 210b, 210c, 210d, 210e, 210f), and spacing of the at least one first air gap (A51, A61, B31, B41, B51, B61) is the same as spacing of the at least one second air gap (A52, A62, B32, B42, B52, B62).

8. The magnetic assembly (100a, 100b, 100c, 100d, 100e, 100f, 200a, 200b, 200c, 200d, 200e, 200f) according to claim 7, wherein the at least one first pillar (242a, 242b, 242c, 242d, 242e, 242f) and the first magnetic core (110a, 110c, 210a, 210b, 210c, 210d, 210e, 210f) are integrally formed, and the at least one second pillar (244a, 244b, 244c, 244d, 244e, 244f) and the second magnetic core (120a, 120d, 220a, 220b, 220c, 220d, 220e, 220f) are integrally formed.

9. The magnetic assembly (100a, 100b, 100c, 100d, 100e, 100f, 200a, 200b, 200c, 200d, 200e, 200f) according to claim 1, wherein the plurality of pillars (140a, 140b, 140c, 140d, 140e, 140f) comprise at least one first pillar (242a, 242b, 242c, 242d, 242e, 242f) and at least one second pillar (244a, 244b, 244c, 244d, 244e, 244f), a height (HI, H3) of the at least one first pillar (242a, 242b, 242c, 242d, 242e, 242f) is different from a height (H2, H4) of the at least one second pillar (244a, 244b, 244c, 244d, 244e, 244f), the plurality of air gaps (A1, A2, A3, A4, B1, B2) comprise at least one first air gap (A51, A61, B31, B41, B51, B61) and at least one second air gap (A52, A62, B32, B42, B52, B62), one of the at least one first pillar (242a, 242b, 242c, 242d, 242e, 242f) and the at least one second pillar (244a, 244b, 244c, 244d, 244e, 244f) is disposed on the first magnetic core (110a, 110c, 210a, 210b, 210c, 210d, 210e, 210f), and the other of the at least one first pillar (242a, 242b, 242c, 242d, 242e, 242f) and the at least one second pillar (244a, 244b, 244c, 244d, 244e, 244f) is disposed on the second magnetic core (120a, 120d, 220a, 220b, 220c, 220d, 220e, 220f), the at least one first air gap (A51, A61, B31, B41, B51, B61) is formed between the at least one first pillar (242a, 242b, 242c, 242d, 242e, 242f) and one of the first magnetic core (110a, 110c, 210a, 210b, 210c, 210d, 210e, 210f) and the second magnetic core (120a, 120d, 220a, 220b, 220c, 220d, 220e, 220f), the at least one second air gap (A52, A62, B32, B42, B52, B62) is formed between the at least one second pillar (244a, 244b, 244c, 244d, 244e, 244f) and the other of the first magnetic core (110a, 110c, 210a, 210b, 210c, 210d, 210e, 210f) and the second magnetic core (120a, 120d, 220a, 220b, 220c, 220d, 220e, 220f), and spacing of the at least one first air gap (A51, A61, B31, B41, B51, B61) is different from spacing of the at least one second air gap (A52, A62, B32, B42, B52, B62).

10. The magnetic assembly (100a, 100b, 100c, 100d, 100e, 100f, 200a, 200b, 200c, 200d, 200e, 200f) according to claim 9, wherein the at least one first pillar (242a, 242b, 242c, 242d, 242e, 242f) and one of the first magnetic core (110a, 110c, 210a, 210b, 210c, 210d, 210e, 210f) and the second magnetic core (120a, 120d, 220a, 220b, 220c, 220d, 220e, 220f) are integrally formed, and the at least one second pillar (244a, 244b, 244c, 244d, 244e, 244f) and the other of the first magnetic core (110a, 110c, 210a, 210b, 210c, 210d, 210e, 210f) and the second magnetic core (120a, 120d, 220a, 220b, 220c, 220d, 220e, 220f) are integrally formed.

11. The magnetic assembly (100a, 100b, 100c, 100d, 100e, 100f, 200a, 200b, 200c, 200d, 200e, 200f) according to claim 1, wherein one of the first magnetic core (110a, 110c, 210a, 210b, 210c, 210d, 210e, 210f) and the second magnetic core (120a, 120d, 220a, 220b, 220c, 220d, 220e, 220f) is in a shape of a flat plate, and the other of the first magnetic core (110a, 110c, 210a, 210b, 210c, 210d, 210e, 210f) and the second magnetic core (120a, 120d, 220a, 220b, 220c, 220d, 220e, 220f) is in a shape of a groove.

12. The magnetic assembly (100a, 100b, 100c, 100d, 100e, 100f, 200a, 200b, 200c, 200d, 200e, 200f) according to claim 1, wherein the first magnetic core (110a, 110c, 210a, 210b, 210c, 210d, 210e, 210f) and the second magnetic core (120a, 120d, 220a, 220b, 220c, 220d, 220e, 220f) are in a shape of a groove, respectively.

13. The magnetic assembly (100a, 100b, 100c, 100d, 100e, 100f, 200a, 200b, 200c, 200d, 200e, 200f) according to claim 1, further comprising:
a plurality of connecting members (150, 250), and the at least one circuit board (130, 230) further has a plurality of connecting holes (134, 234) around, wherein the plurality of connecting members (150, 250) respectively correspond to the plurality of pass through connecting holes (134, 234).
